(19) Europäisches Patentamt

European Patent Office

Office européen des brevets

(11) **EP 0 700 598 B1**

(12) **EUROPEAN PATENT SPECIFICATION**

(45) Date of publication and mention
of the grant of the patent:
**01.08.2001 Bulletin 2001/31**

(51) Int Cl.⁷: $H03K\ 3/01$, H03K 17/687, H02M 3/07

(21) Application number: **93914255.0**

(22) Date of filing: **28.05.1993**

(86) International application number:
**PCT/US93/05133**

(87) International publication number:
**WO 94/28629 (08.12.1994 Gazette 1994/27)**

(54) **NEGATIVE VOLTAGE GENERATOR FOR FLASH EPROM DESIGN**

Generator für negative Spannungen für Flash-EPROMS

GENERATEUR DE TENSION NEGATIVE DESTINE A UNE STRUCTURE DE MEMOIRE MORTE
PROGRAMMABLE ELECTRIQUEMENT FLASH (EPROM FLASH)

(84) Designated Contracting States:
**DE FR GB IT**

(43) Date of publication of application:
**13.03.1996 Bulletin 1996/11**

(73) Proprietor: **Macronix International Co., Ltd.
Hsinchu (TW)**

(72) Inventors:
• **LIN, Tien-Ler
Cupertino, CA 95014 (US)**
• **CHAO, Liang No. 41
Min-Hsian Street Hsinchu (TW)**

(74) Representative: **Harris, Ian Richard
D. Young & Co.,
21 New Fetter Lane
London EC4A 1DA (GB)**

(56) References cited:
**EP-A- 0 525 678        US-A- 3 470 443
US-A- 4 405 868        US-A- 4 636 930
US-A- 5 065 091        US-A- 5 121 007**

• **IEEE International Solid-State Circuits
Conference, 32 (1989) February, New York,
pages 132, 133, 313, "Nonvolatile Memories: A
5V-Only 256k Bit Flash EEPROM", XP000066856**

Note: Within nine months from the publication of the mention of the grant of the European patent, any person may give
notice to the European Patent Office of opposition to the European patent granted. Notice of opposition shall be filed in
a written reasoned statement. It shall not be deemed to have been filed until the opposition fee has been paid. (Art.
99(1) European Patent Convention).

## Description

CROSS-REFERENCE TO RELATED APPLICATIONS

The present application is related to EP application 92 300 789.2 published under EP-A-0 552 531 on 28.07.1993.

BACKGROUND OF THE INVENTION

Field of the Invention

The present invention relates to negative voltage generators responsive to positive voltage power supplies, and more particularly, to providing high negative voltages in integrated circuits such as FLASH EPROM memory devices.

Description of Related Art

Different levels of internal voltage are required during various modes of operation of FLASH EPROM (electrically programmable read only memory) integrated circuits for electrically erasing, programming or reading a memory cell. The memory cells in FLASH EPROM are formed using so-called floating gate transistors in which the data is stored by charging or discharging the floating gate.

The act of charging the floating gate is termed the program mode for a FLASH EPROM. This is typically accomplished using hot electron injection induced by establishing a large positive voltage between the gate and source, as much as 12 volts, and a positive voltage between the drain and source, for instance, 7 volts.

The act of discharging the floating gate is called the erase mode for a FLASH EPROM. This erase function is typically carried out through Fowler-Nordheim tunneling induced by establishing a large positive voltage from the source to gate, while floating the drain of the memory cell. This positive voltage can be as much as 12 volts.

However, when applying 12 volts to the source and grounding the gate, very high reverse voltage is developed between source and substrate, the generation of hot holes is increased, and the memory cell may exhibit "hot hole trapping." Hot hole trapping degrades endurance cycling performance of the device.

In order to alleviate hot hole trapping during an erase operation, a negative voltage may be applied to the gate of the memory cell. Instead of applying 12 volts to the source and grounding the gate, a large negative voltage, such as less then -7.5 volts, may be applied to the gate and a lower positive voltage may be applied to the source, for example, 7.0 volts. Thus, much lower voltages are developed between the source and substrate and hot hole generation is suppressed.

However, FLASH EPROM memory is typically supplied with two external positive power sources rather than a negative power supply. The first positive power source, $V_{DD}$, is applied at power up and is typically used during the read operation. $V_{DD}$ is usually $5.0 \pm 0.5$ volts. The second positive power source, $V_{PP}$, is typically applied during program or erase mode, and is typically $12.0 \pm 0.6$ volts. Therefore, in order to supply negative voltage to the EPROM cells, a relatively large negative voltage must be generated from either of the two positive power supplies.

Therefore, it is desirable to provide a circuit used in supplying a relatively precise high negative voltage without regulation, to FLASH EPROM memory cells, or other environments relying on positive power supplies from a positive power supply.

US-A-4,636,930 discloses a charge pump circuit for converting a unipolar supply voltage to a bipolar supply voltage of a greater magnitude.

EP-A-0.525.678 describes a nonvolatile semiconductor memory device in which a negative voltage is applied to a gate electrode of a memory cell transistor during an erase mode. and in particular describes a row decoder circuit employed within the nonvolatile semiconductor memory device. Further the article "Nonvolatile Memories: A 5V-Only 256k Bit CMOS Flash EEPROM" published in IEEE International Solid-State Circuits Conference. 32 (1989) February. New York. pages 132, 133, 313, describes a circuit for supplying a negative voltage.

US-A-3,470,443 describes an apparatus for converting the output of a positive DC voltage source to a negative DC voltage of lower magnitude.

US-A-5,065,091 describes a substrate voltage generating circuit in which a value of the voltage generated by the substrate voltage generating circuit is changed corresponding to a switching of an operational mode of a semiconductor integrated circuit device from a normal mode to a test mode.

SUMMARY OF THE INVENTION

The present invention provides a circuit for generating from first and second positive voltages a negative voltage at an output node, comprising: a clock driver for receiving the first positive voltage and generating a positive clock signal having an amplitude between ground and the first positive voltage; a positive voltage input arranged to receive the second positive voltage; first means, coupled to the positive voltage input and the clock driver, to generate a positive periodic signal; and second means, coupled to the first means, for generating the negative voltage on the output node in response to the positive periodic signal; the circuit being characterised by: the first means comprising a voltage converter, coupled to the positive voltage input and the clock driver, the voltage converter comprising :

a voltage drop circuit to drop the second positive voltage to a particular voltage; and

a driver, coupled to the clock driver, to convert the clock signal to a positive periodic signal in response to the clock signal and the particular voltage, the positive periodic signal having a particular amplitude greater than the first positive voltage.

In accordance with preferred embodiments of the present invention, a circuit is provided for generating negative voltage in an integrated circuit, in response to a positive voltage source. In particular, a FLASH EPROM integrated circuit, according to an embodiment of the present invention, presents a negative voltage generator responsive to high positive programming potential $V_{pp}$ to supply a negative voltage.

According to one embodiment of the present invention. the circuit for providing negative voltage is based on a charge pump driven by a periodic signal oscillating between essentially ground and a positive potential. The charge pump includes a first capacitor having a first terminal means receiving the positive periodic signal. The second terminal of the capacitor is clamped to a reference potential near ground, so that the second terminal does not rise above the reference potential. A switch, such as a diode connected transistor, coupled between the second terminal and an output node connects the second terminal to the output node when the voltage at the second terminal falls below the voltage on the output node, to pump the output node to a negative potential.

The periodic signal is generated by a voltage converter coupled to the high program potential $V_{PP}$, which converts a $V_{DD}$ level clock to the periodic signal.

The voltage converter of an embodiment is comprised basically of a diode drop circuit which allows adjustment of the voltage, and a high voltage inverter driven by the $V_{DD}$ level clock signal. The voltage drop circuit enables the designer to select a magnitude for the periodic signal, and thereby a magnitude of the negative voltage generated by the charge pump as suits the needs of a particular design. By using the high programming potential $V_{PP}$ in connection with the voltage converter, a very wide range of negative voltages is available, including negative voltage having an absolute value of greater than the input potential $V_{DD}$. Thus, in standard FLASH EPROM integrated circuits, in which the programming potential $V_{PP}$ is energized to a +12 volts during erase mode, and the chip power supply $V_{DD}$ is held at a +5 volts, a negative voltage may be generated which is more negative than -5 volts, as is explained in detail below.

According to an embodiment of the present invention, the charge pump includes a first P-channel transistor with the source and drain coupled to the positive periodic signal configured as the input capacitor for the charge pump. A second P-channel transistor with the gate and drain coupled to ground and the source coupled to the gate of the first transistor is configured as a clamping diode. A third P-channel transistor is configured as a switching diode with the drain and gate coupled to the first transistor gate. An output node is coupled between the source of the third transistor and to ground.

The first P-channel transistor which is configured as the input capacitor, according to the preferred embodiment, is formed in an n-well which is connected to receive the periodic signal. This prevents high voltage from being accumulated across the gate of the first transistor during the negative voltage generation.

According to one embodiment of the present invention, a FLASH EPROM integrated memory circuit using the negative voltage generator in erase operations is provided. The memory circuit comprises K subarrays having M columns and N rows of floating gate storage transistors. The storage transistors in the subarrays have respective control gates, sources and drains. Addressing means is coupled to the K subarrays for generating address signals to access selective floating gate storage transistors. A plurality of wordlines is coupled to the control gates of the storage cells in respective rows.

A plurality of global bitlines is coupled to respective columns of cells. A plurality of local bitlines are coupled to the drains of the N storage cells in the respective column within a respective subarray. Means for selectively connecting the local bitlines in a subarray of storage cells to the corresponding global bitlines is provided and responsive to address signals. A plurality of local virtual ground lines are coupled to the sources of the N storage cells in respective columns within a respective subarray. Means for connecting the local virtual ground lines in a subarray of storage cells with a virtual ground terminal is provided. And columns select means, coupled to the global bitlines and the addressing means, selectively enables access to the N columns of storage cells in response to the address signals.

Finally, means which are coupled to the plurality of wordlines and the plurality of virtual ground lines, supply a negative gate erasing potential on selected wordlines and a positive voltage on virtual ground lines to remove charge in the floating gate of the selected floating gate storage transistors in response to the address signals during sector erase mode, and erase whole chip during chip erase mode.

Other aspects and advantages of the present invention can be seen upon review of the figures, the detailed description, and the claims which follow.

BRIEF DESCRIPTION OF THE FIGURES

Fig. 1 is a schematic diagram for providing negative voltage from a positive voltage source according to the present invention.

Figs. 2a-c are HSPICE simulation results of the schematic in Fig. 1 according to the present invention.

Figs. 3a-c are HSPICE simulation results of the schematic in Fig. 1 when the n-well of transistor 41 is coupled to $V_{PP}$.

Fig. 4 is a schematic diagram of a FLASH EPROM circuit according to the present invention.

Fig. 5 is a schematic diagram illustrating the layout of two subarrays of FLASH EPROM cells according to the present invention.

Fig. 6 is a block diagram of a FLASH EPROM integrated circuit according to the present invention.

## DETAILED DESCRIPTION OF THE PREFERRED EMBODIMENT

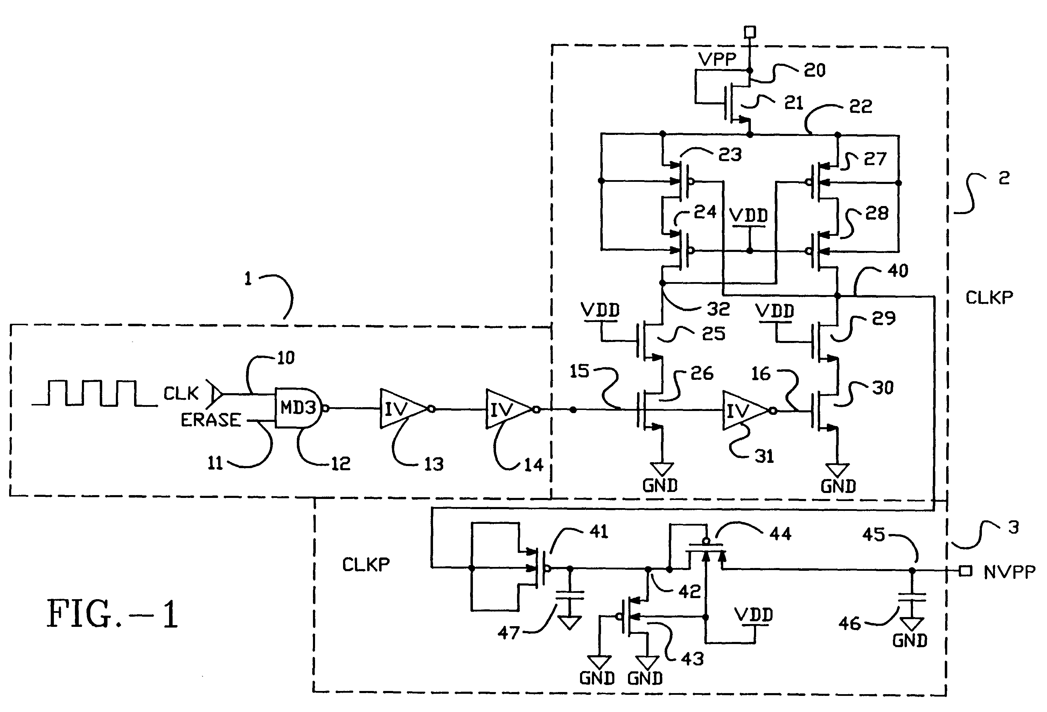

Fig. 1 is a schematic diagram illustrating a circuit generating a negative voltage according to the present invention. The circuit in Fig. 1 consists generally of three sections: oscillator 1, voltage converter 2, and charge pump 3.

Oscillator 1 comprises NAND gate 1.2 and inverters 13 and 14. An ERASE signal, which is driven to the operating supply voltage $V_{DD}$ is applied during erase mode to NAND gate 12 on line 11. $V_{DD}$ (typically 5.0 ± 0.5 volts) is generally a voltage supplied to FLASH EPROM memory during power-on operations. Oscillator signal CLK is applied to NAND gate 12 on line 10 allowing for NAND gate 12 to output a periodic signal through inverters 13 and 14 on line 15 which swings between essentially ground and VDD.

The voltage converter receives the output on line 15 of the oscillator, and converts it to a periodic signal CLKP on line 40 which swings between a selected higher positive voltage and ground, such as 10.5 volts (which is $V_{PP}$-$V_{TN}$ of transistor 21) in the embodiment disclosed. The voltage converter is driven by the high programming potential $V_{PP}$, and includes a voltage drop circuit which consists essentially of the diode connected transistor 21, which generates a selected voltage on node 22. The value of the voltage on node 22 can be controlled as known in the art by including a string of diodes between $V_{PP}$ and node 22, or using other techniques as known in the art. The voltage on node 22 serves as the high voltage for the periodic signal CLKP on line 40.

Transistors 23-30 and inverter 31 comprise basically a high voltage inverter which is driven by the periodic signal on line 15. Thus, a high positive voltage periodic signal on line 40 is supplied at the output of voltage converter 2. A charge pump 3 receives the periodic signal and generates a negative voltage NVPP on node 45. The charge pump includes an input capacitor composed in the preferred system of P-channel transistor 41 having its source and drain coupled to line 40, and its gate operating as an output node 42. The output node 42 is coupled across diode connected transistor 43 to ground, and across diode connected transistor 44 to the output node 45. An inherent output node capacitance 46 is shown connected between node 45 and ground. Node 42 inherently includes a parasitic capacitance, represented in the diagram by the element 47.

The input capacitor 41 couples the signal on line 40 to node 42. The diode connected transistor 43 clamps node 42 at a reference voltage about 1 P-channel threshold $|V_{TP}|$ above ground. Thus, on a rising edge of the signal CLKP on line 40, transistor 43 will clamp node 42 to about 1.3 volts.

The diode connected transistor 44 is non-conducting unless the voltage at node 42 falls below a threshold voltage of about 1.3 volts relative to node 45. Thus, on a falling edge of the signal CLKP on line 40, node 42 is decoupled to a negative potential and transistor 44 will conduct when node 42 falls about 1.3 volt below node 45. Thus, when node 42 is below node 45, transistor 44 turns on and injects charge into the output node capacitance 46, to pump the voltage in $V_{PP}$ negative.

The equation of final voltage for signal NVPP is:

$$NVPP = - [(V_{PP} - V_{tn}) * C_R - 2 * | V_{tp}|]$$

where:

$V_{PP}$ = the input voltage;
$V_{tn}$ = the threshold voltage of N-channel type transistor 21 with "body effect" (about 1.5V);
$V_{tp}$ = the threshold voltage of P-channel type transistor 43 or 44 with "body effect" (about -1.3V);

$$C_R = C_{41} \div (C_{41} + C_{47})$$

where:

$C_{41}$    the capacitance of transistor 41;
$C_{47}$ =    the line or parasitic capacitance.

Therefore, based on the above equation and as described in detail below, approximately -7.5±0.45 volts is outputted on node 45 as signal NVPP. The magnitude of NVPP can be adjusted by changing the number n of diodes in the diode string ($n*|V_{TN}|$) above node 22. Furthermore, the negative voltage is relatively precise without the requirement for complex voltage regulator circuitry.

The function of the voltage converter 2 is described in more detail as follow. In particular, $V_{PP}$ is applied to line 20 and is typically 12.0 ± 0.6 volts during a program or erase mode. Line 20 is coupled to the drain of N-channel type transistor 21. Line 20 is also coupled to the gate of transistor 21 with the source coupled to line 22.

Line 22 is coupled to P-channel type transistors 23, 24, 27 and 28. Specifically, line 22 is coupled to the source of transistors 23 and 27. In addition, line 22 is coupled to the n-well of transistors 23, 24, 27 and 28 in order to prevent "body effect" voltage drops. The drain of transistor 23 is coupled to the source of transistor 24. Similarly, the drain of transistor 27 is coupled to the source of transistor 28.

Transistors 24 and 28 are provided for reducing the voltage stress across transistors 23 and 27 during transition. As described below, if transistors 24 and 28 were not included in the circuit, a source-to-drain voltage drop of 10.5 would alternately occur across transistors 23 and 27 during transition. This large of a voltage drop would cause a "soft breakdown" of transistors 23 and 27. In other words, the transistors would be operating beyond the "saturation" region in which voltage drops across a transistor's source/drain does not produce constant current. Beyond the "saturation" region, current increases exponentially rather than producing constant current.

$V_{DD}$ is coupled to the gates of transistors 24 and 28, while the gate of transistor 27 is coupled to line 32 and the gate of transistor 23 is coupled to line 40. This latch-like configuration allows 10.5 volts to be alternately applied to the gates of transistors 23 and 27, eliminating the DC current.

N-channel type transistors 25 and 29 are also coupled to lines 32 and 40, respectively. Line 32 is coupled to the drain of transistor 25 with the source of transistor 25 coupled to the drain of N-channel type transistor 26. $V_{DD}$ is coupled to the gate of transistor 25 and transistor 29. Line 40 is coupled to the drain of transistor 29 and the source of transistor 29 is coupled to the drain of N-channel type transistor 30. Finally, the sources of transistors 30 and 26 are coupled to a reference potential (ground). The gate of transistor 26 is coupled to line 15. The gate of transistor 30 is driven by line 16 at the output of inverter 31. The input to inverter 31 is line 15.

Transistors 25 and 29, as with transistors 24 and 28, are provided to eliminate "soft breakdown." Transistors 25 and 29 act as a voltage drop circuit preventing the full 10.5 volts on lines 32 or 40 to be applied across transistors 26 and 30 during transition. If the 10.5 volts on line 32 or 40 was directly applied to transistors 26 and 30, the transistors would undergo "soft breakdown."

The alternating conductivity of transistors 26 and 30 allow signal CLKP, in the present embodiment an approximately 10.5 volt periodic signal, to be outputted on line 40. Approximately, 10.5 volts is applied to line 22 based on a 1.5 volt drop $V_T$ voltage drop of transistor 21. This 10.5 volts will be periodically applied to line 40 when transistor 26 is conductive. When transistor 26 is in a conductive state, transistor 30 is in a non-conductive state allowing for the 10.5 volts on line 22 to pass through transistors 27 and 28 onto line 40. Alternatively, when transistor 30 is in a conductive state and transistor 26 is in a non-conductive state, CLKP is connected to ground through transistors 29 and 30. Accordingly, signal CLKP swinging between +10.5 volts and ground is outputted on line 40 to charge pump 3 which generates signal NVPP, in the present embodiment approximately -7.5 volts, on node 45. To achieve other values for NVPP the amplitude of CLKP can be adjusted.

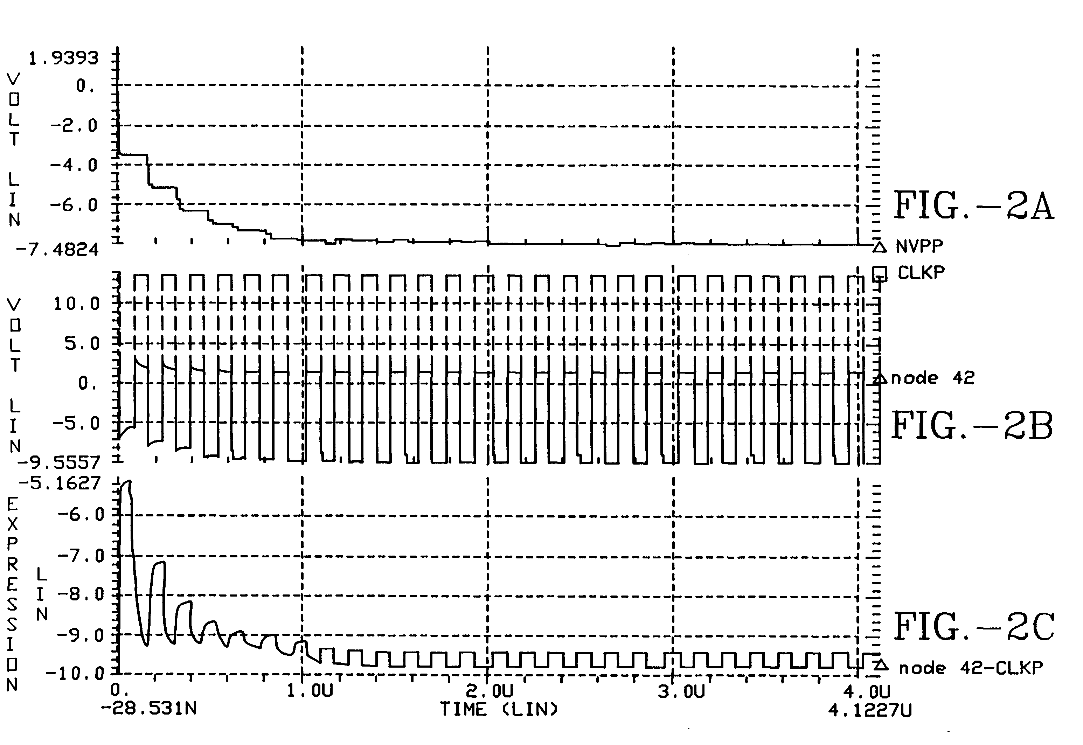

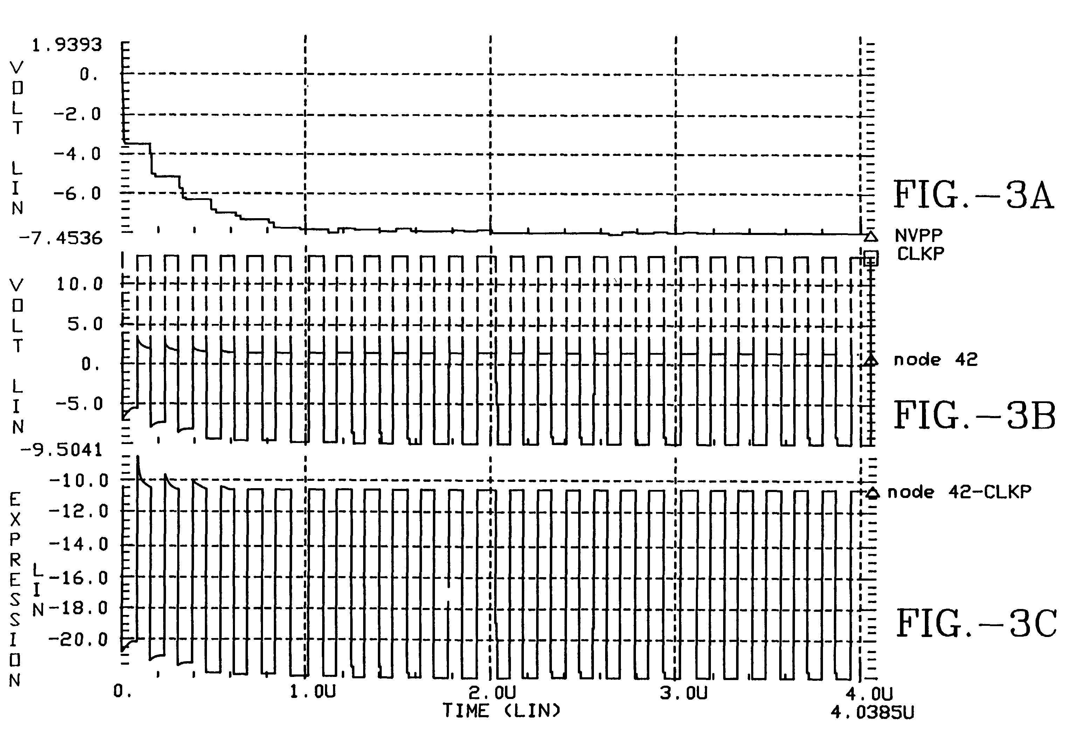

Line 40 is coupled to P-channel transistor 41 by connecting the n-well, source and drain to line 40 creating a capacitor. The n-well of transistor 41 is purposely tied to signal CLKP to reduce voltage stress across the transistor oxide which is typically 250Å. Tying signal CLKP to the n-well of transistor 41 allows the voltage across transistor 41 to be less than 10 volts, as seen in Fig. 2c. If the n-well of transistor 41 is not tied to signal CLKP and tied to $V_{PP}$, the voltage across transistor 41 would be beyond the breakdown voltage of transistor 41. The voltage stress of transistor 41, as seen in Fig. 3c, varies between -10 volts and -21 volts. This voltage is beyond the breakdown voltage of a 250Å gate-oxide transistor.

The timing diagram associated with the charge pump 3 in Fig. 1 can be seen in Figs. 2a-c. Fig. 2a shows the output at node 45 or signal NVPP. Fig. 2b illustrates the voltages at node 42 as depicted by bold lines and signal CLKP illustrated by dashed lines. Finally, Fig. 2c shows the difference in voltage between node 42 and line 40 or the voltage stress across transistor 41.

The operation of charge pump 3 in Fig. 1 along with its timing diagram in Figs. 2a-c will now be described. Signal CLKP from voltage converter 2 is a periodic signal with an amplitude of approximately 10.5 volts and a reference voltage level of approximately 0 volts. At time $T_0$, signal CLKP is 0 volts, node 42 is approximately 1.3 volts and NVPP is approximately 2 volts due to connections to other circuitry not shown. The approximate 1.3 volts at node 42 is equal to the absolute value of the threshold voltage of transistor 43. At time $T_1$, signal CLKP transitions from 0 volts to 10.5 volts and thus 10.5 volts is applied to transistor 41. Transistor 41 is capacitor configured (10 picofarads in this simulation). In addition to the capacitance associated with transistor 41, there is inherent parasitic capacitance illustrated by element 47. The output node is around 20 picofarads in this simulation. Typically, capacitor element 47 is on the order of less than 0.5 picofarads. Transistor 41 and capacitor element 47 act as two capacitors in series coupled between a 10.5 volt source and ground potential. Based upon these capacitance values, transistor 41 and capacitor element 47 create a coupling ratio on node 42 of approximately 95%. The 95% number is derived by the equation $C_{41}/(C_{41} + C_{47})$ set out above. Accordingly, 95% of the 10.5 volts or approximately 10 volts is supplied to node 42. The positive voltage at node 42 is quickly clamped to the 1.3 voltage threshold drop of transistor 42 being diode coupled to a ground potential source. At time $T_2$, the 10.5 volts of signal CLKP transitions to 0 volts. Accordingly, node 42 undergoes a -10 voltage drop as seen in Fig. 2b. As the voltage on node 42 follows the falling edge of signal CLKP a negative voltage is established at node 42. With a negative voltage now on node 42, transistor 44 is turned on allowing the negative voltage of node 42 to charge output node.

Likewise, with the falling edge of each 10.5 volt pulse to node 42, the voltage difference across transistor 44 is slowly decreased until about -7.5 volts is reached at node 45.

Figs. 3a-c are timing diagrams of Fig. 1 with the n-well of transistor 41 tied to $V_{PP}$. As can be seen, Figs. 3a and 3b are substantially the same as Figs. 2a and 2b. By tying the n-well of transistor 41 to $V_{PP}$, signal NVPP and the voltage at node 42 are still approximately the same as in Figs. 2a and 2b. However, the voltage stress across transistor 41 as shown by the timing diagrams in Figs. 2c and 3c are substantially different. The voltage stress exhibited in Fig. 3c ranges from -10 to -21 volts while the voltage in Fig. 2c never exceeds -10.0 volts. The voltage range in Fig. 3c is beyond the breakdown voltage of transistor 41. Accordingly, tying the n-well of transistor 41 to signal CLKP reduces voltage stress and eliminates the breakdown of transistor 41.

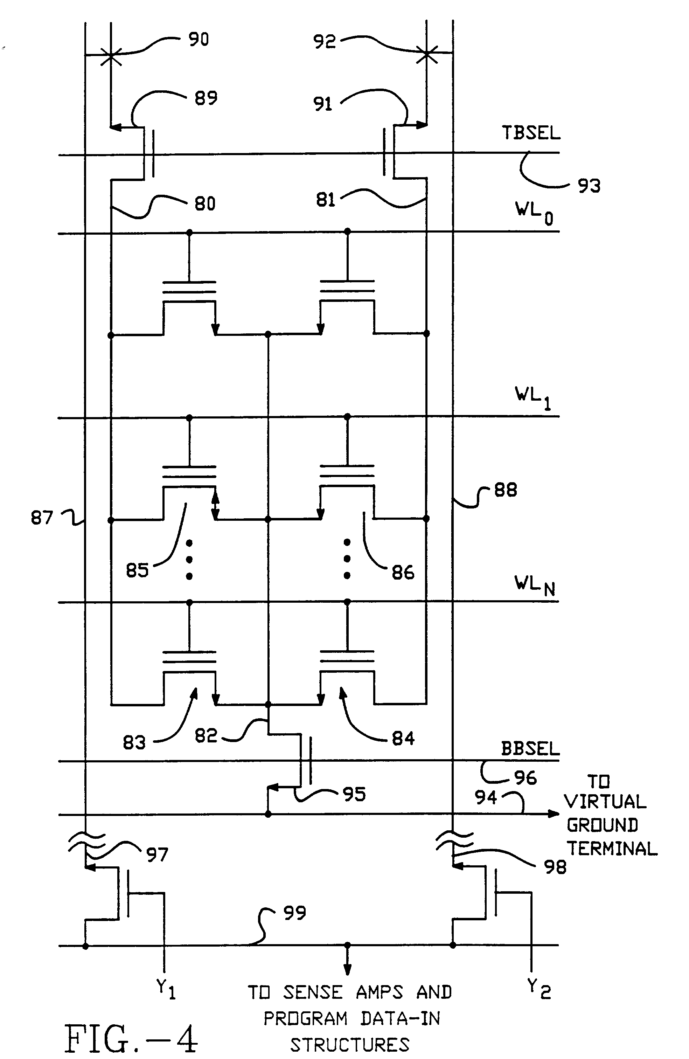

Fig. 4 illustrates the drain-source-drain configuration of the FLASH EPROM circuit according to the present embodiment. More details of the memory design are provided in the above cross-referenced EP-A-0 552 531. The circuit includes a first local bitline 80 and a second local bitline 81. The first and second local bitlines 80, 81 are implemented by buried diffusion conductors as described below. Also included is a local virtual ground line 82 implemented by buried diffusion. A plurality of floating gate transistors having gates, drains and sources are coupled to the local bitlines 80, 81 and local virtual ground line 82. The sources of the plurality of transistors are coupled to the local virtual ground line 82. The drains of a first column of transistors, generally 83, are coupled to the first local bitline 80, and the drains of a second column of transistors, generally 84, are coupled to the second local bitline 81. The gates of the floating gate transistors are coupled to wordlines $WL_0$ through $WL_N$, where each wordline (e.g., $WL_1$) is coupled to the gate of a transistor (e.g., transistor 85) connected to the first local bitline 80 and a transistor (e.g., transistor 86) connected to the second local bitline 81. Thus, transistors 85 and 86 can be considered a two transistor cell with a shared source diffusion.

The act of charging the floating gate is called the program step for the FLASH EPROM cell. This is accomplished through hot electron injection by establishing a large positive voltage between the gate and the source, such as 12 volts, and a positive voltage between the drain and the source, such as 7 volts.

The act of discharging the floating gate is called the erase step for the FLASH EPROM cell. This is accomplished through the F-N tunneling mechanism between the floating gate and the source (source erase) or between the floating gate and the substrate (channel erase). The source erasing is performed by applying a positive bias to the source, seven volts, while the gate is negatively biased, such as -7.5 volts. The channel erasing is performed by applying a negative bias to the gate and/or a positive bias to the substrate.

Accordingly, signal NVPP of Fig. 1 is applied to the floating gates by way of $WL_0$ through $WL_N$ while a positive voltage ranging from around 5.5 to 8.0 volts is applied to line 82 in order to allow for erasing of the FLASH EPROM cell. Using a relatively large negative wordline voltage, such as signal NVPP at -7.5 volts, "hot hole trapping" is alleviated and the array $V_{SS}$ voltage level is reduced.

A first global bitline 87 and a second global bitline 88 are associated with each drain-source-drain block as shown in Fig. 4. The first global bitline 87 is coupled to the source of top block select transistor 89 through a metal-to-diffusion contact 90. Similarly, the second global bitline 88 is coupled to the source of top block select transistor 91 through a metal-to-diffusion contact 92. The drains of the top block select transistors 89, 91 are coupled to the first and second local bitlines 80 and 81, respectively. The gates of the top block selector transistors 89, 91 are controlled by a top block select signal TBSEL on line 93.

The local virtual ground line 82 is coupled to a virtual ground terminal across conductor 94 through bottom block selector transistor 95. The drain of the bottom block select transistor 95 is coupled to the local virtual ground line 82. The source of the bottom block select transistor 95 is coupled to the conductor 94. The gate of the bottom block select transistor 95 is controlled by a bottom block select signal BBSEL across line 96. During erase, conductor 94 is at 7 volts and when the bitline is selected, the corresponding BBSEL is at 12 volts to pass 7 volts to local source line 82. In the preferred system, the conductor 94 is a buried diffusion conductor which extends to a metal-to-diffusion contact at a position displaced horizontally through the array, which provides contact to a vertical metal virtual ground bus.

The global bitlines extend vertically through the array to respective column select transistors 97, 98, through which a selected global bitline is coupled to sense amps and program data-in circuitry (not shown). Thus, the source of column select transistor 97 is coupled to global bitline 87, the gate of column select transistor 97 is coupled to a column decode signal $Y_1$, and the drain of the column select transistor 97 is coupled to conductor 99.

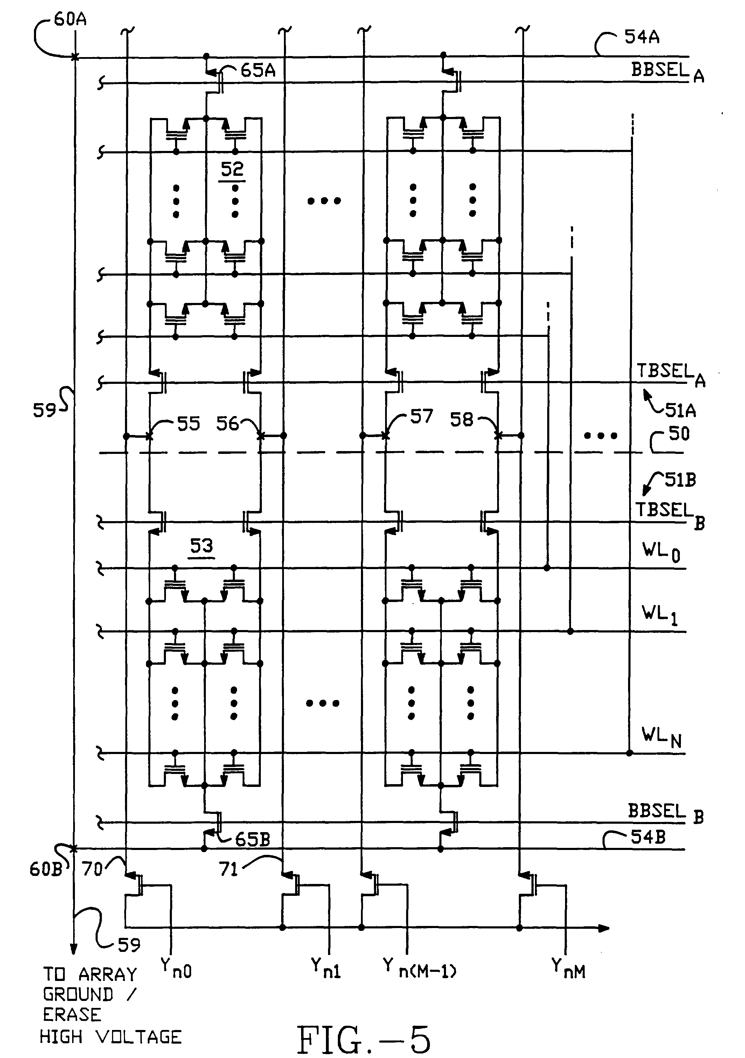

The blocks of FLASH EPROM cells as shown in Fig. 4 are configured into a plurality of subarrays as illustrated in Fig. 5. Fig. 5 illustrates two subarrays within a larger integrated circuit. The subarrays are divided generally along dotted line 50 and include subarray 51A generally above the line 50 and subarray 51B generally below the line 50. A first block 52 is laid out in a mirror image with a second block 53 along a given bitline pair (e.g., bitlines 70, 71). As one proceeds up the bitline pair, the memory subarrays are flipped so as to share virtual ground conductors 54A, 54B (buried diffusion) and metal-to-diffusion contacts 55, 56, 57, 58. The virtual ground conductors 54A, 54B extend horizontally across the array to a vertical virtual ground metal line 59 through metal-to-diffusion contacts 60A, 60B. The subarrays repeat on opposite sides of the metal virtual ground line 59 so that adjacent subarrays share a metal virtual ground line 59. The metal virtual ground line 59 is coupled to array ground and erase high voltage circuitry. Thus, the subarray layout requires two metal contact pitches per column of two transistor cells for the global bitlines and one metal contact pitch per subarray for the metal virtual ground line 59.

Furthermore, two subarrays as illustrated in Fig. 5 may share wordline signals because of the additional decoding provided by the top and bottom block select signals TBSELA, TBSELB, BBSELA, and BBSELB.

In one preferred system, each subarray includes 8 blocks 32 two transistor cells and wordlines deep, so that there are a total of 16 global bitlines and 32 wordlines, providing a 512 cell subarray.

As can be seen, the architecture according to the present invention provides a sectored FLASH EPROM array. This is beneficial because the source and drain of transistors in non-selected subarrays during a read, program or erase cycle may be isolated from the currents and voltages on the bitlines and virtual ground lines. Thus, during a read operation, sensing is improved because leakage current from subarrays not selected does not contribute to current on the bitlines. During the program and erase operations, the high voltages of the virtual ground line, and the bitlines, are isolated from the unselected blocks. This allows a sectored erase operation.

It will be appreciated that the bottom block select transistors (e.g., transistors 65A, 65B) may not be necessary in a given implementation. Also, these block select transistors may share a bottom block select signal with an adjacent subarray, as illustrated below with respect to Fig. 5. Alternatively, the bottom block select transistors (e.g., 65A, 65B) may be replaced by single isolation transistors adjacent the virtual ground terminals 60A, 60B.

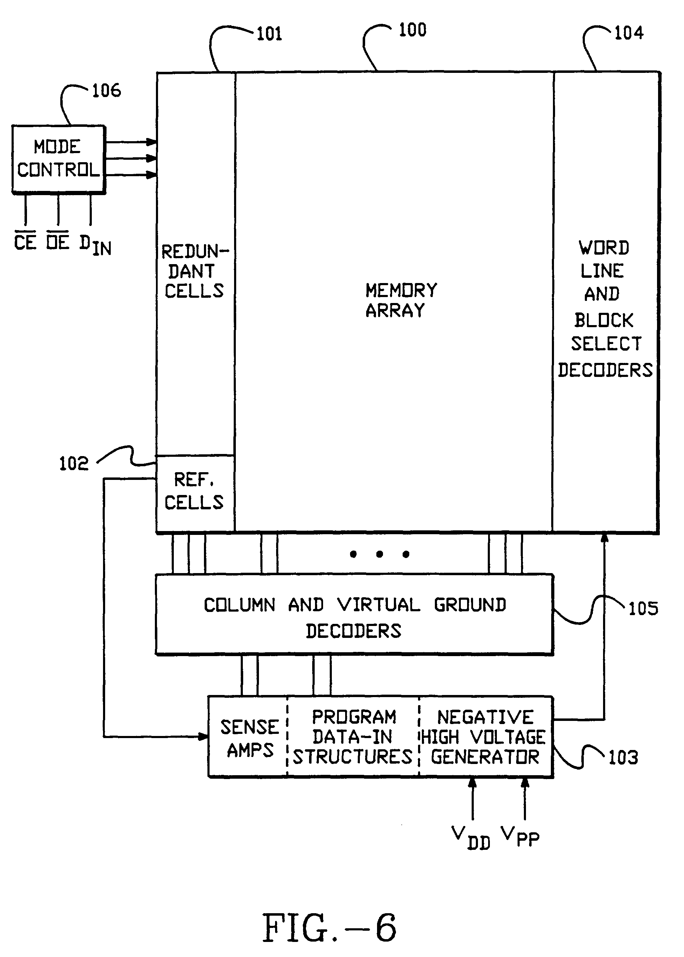

Fig. 6 is a schematic block diagram of a FLASH EPROM integrated circuit according to the present invention. The FLASH EPROM includes a memory array 100 implemented as shown in Fig. 5. A plurality of redundant cells 101 is implemented in the preferred system so that any failed cells in the memory array may be replaced by redundant cells 101. In addition, the circuit includes a plurality of reference cells 102, block 103 which includes sense amps, program data-in circuits, and negative high voltage generator, and block 104 which includes wordline and block select decoders, and block 105 which includes column decoders and virtual ground decoders.

The circuit of Fig. 1 which provides negative voltage for erasing memory array 100 is found in the negative high voltage generator in block 103. $V_{DD}$ and $V_{PP}$ are applied to the negative high voltage generator allowing for the negative voltage provided by the circuit of Fig. 1 to be applied through wordlines to individual memory cells in memory array 100.

The reference cells 102 may also be used in the generation of program and read voltages. This redundant cell architecture is made possible by the segmented architecture of the FLASH EPROM arrays as discussed above.

The wordline and block select decoders 104 and the column and virtual ground decoder 105 are programmable after testing so that redundant cells may replace inoperable cells in the memory array 100.

In addition, the circuit includes a mode control circuit 106 responsive to the chip enable $\overline{CE}$, output enable $\overline{OE}$, and data-in $D_{IN}$ signals for the chip. The circuit 106 controls the erase, program and read operations, and the virtual ground, drain and wordline voltages used during the various operations. This circuit may be implemented for instance as in U.S. Patent No. 5,053,990 to Kreifels, et al.

In conclusion, a circuit for providing a negative voltage to the wordlines or floating gates of a plurality of FLASH EPROM cells is provided. The circuit comprises an oscillator and voltage converter using the $V_{PP}$ voltage source to produce a CLKP signal. CLKP signal is a periodic signal, coupled to a charge pump comprising three transistors producing the negative voltage in response to CLKP signal. The first transistor acts as a capacitor. The second transistor and third transistor act as a diode switch supplying a negative voltage to the output node.

**Claims**

1. A circuit for generating from first and second positive voltages a negative voltage at an output node, comprising:

   a clock driver (1) for receiving the first positive voltage and generating a positive clock signal having an amplitude between ground and the first positive voltage;
   a positive voltage input arranged to receive the second positive voltage;
   first means, coupled to the positive voltage input and the clock driver (1), to generate a positive periodic signal; and
   second means, coupled to the first means, for generating the negative voltage on the output node in response to the positive periodic signal; the circuit being characterised by:
   the first means comprising a voltage converter (2), coupled to the positive voltage input and the clock driver (1), the voltage converter comprising:

   a voltage drop circuit (21) to drop the second positive voltage to a particular voltage;

and

a driver, coupled to the clock driver, to convert the clock signal to a positive periodic signal in response to the clock signal and the particular voltage, the positive periodic signal having a particular amplitude greater than the first positive voltage.

2. A circuit as claimed in Claim 1, wherein the driver comprises a first transistor (26) driven by the positive clock signal, and a second transistor (30) driven by an inverted version of the positive clock signal, such that the first and second transistors have alternating conductivity causing the positive periodic signal to be generated.

3. A circuit as claimed in Claim 2, wherein the driver further comprises a latch-like configuration of transistors (23, 24, 27, 28) connected between the voltage drop circuit (21) and the first and second transistors, and arranged such that the particular voltage generated by the voltage drop circuit is alternately applied to the gates of transistors within the latch-like configuration to eliminate DC current.

4. A circuit as claimed in Claim 3, wherein the driver further comprises a second voltage drop circuit (25, 29) connected between the latch-like configuration (23, 24, 27, 28) and the first and second transistors (26, 30) to prevent the entire particular voltage being applied across the first or second transistors during transition.

5. The circuit of Claim 1, wherein the second means for generating negative voltage comprises a charge pump (3).

6. The circuit of Claim 5, wherein the output node has capacitance and the charge pump (3) includes:

a first capacitor (41) having a first terminal and a second terminal, the first terminal coupled to the voltage converter (2) to receive the positive periodic signal;
a clamp circuit (43) coupled to the second terminal of the first capacitor, to clamp the second terminal to a maximum potential; and
a switch (44), coupled between the second terminal of the first capacitor (41) and the output node, having a conductive state when voltage on the second terminal of the first capacitor falls below voltage on the output node.

7. The circuit of claim 6, wherein the first capacitor comprises:

a capacitor configured transistor (41) having a source and drain coupled to the first terminal of the first capacitor and a gate coupled to the second terminal of the first capacitor.

8. The circuit of claim 7, wherein the capacitor configured transistor consists of a p-channel MOS transistor, including an n-well coupled to the first terminal of the first capacitor.

9. The circuit of claim 6, wherein the clamp circuit comprises:

a diode configured transistor (43), coupled between the second terminal of the first capacitor and ground.

10. The circuit of claim 6, wherein the switch comprises:

a diode configured transistor (44), coupled between the second terminal of the first capacitor and the output node.

11. The circuit of claim 5, wherein the charge pump includes:

a capacitor configured transistor (41) having a source and drain coupled to a first terminal and a gate coupled to a second terminal;
a first diode configured transistor (43), coupled between the second terminal of the capacitor configured transistor and ground; and
a second diode configured transistor (44), coupled between the second terminal of the capacitor configured transistor and the output node.

12. The circuit of Claim 11, wherein the capacitor configured transistor, first diode configured transistor and second diode configured transistor comprise P-channel transistors.

13. The circuit of Claim 12, wherein the capacitor configured transistor (41) comprises an n-well connected to receive the positive periodic signal.

14. The circuit of claim 1, wherein the first positive voltage corresponds to an operating voltage less than the second positive voltage.

15. A memory circuit arranged to receive an operating supply voltage and a programming supply voltage, comprising:

a non-volatile memory cell having a gate and a source;
a circuit for generating a negative voltage as claimed in any of claims 1 to 14, the circuit being coupled to the programming supply voltage as the second positive voltage, to generate the negative voltage on an output node; and
means for connecting the gate of the non-volatile memory cell to the output node of the negative voltage circuit to erase the non-volatile memory cell.

**16.** The circuit of claim 15, wherein within the negative voltage circuit:

the clock driver (1) is arranged to supply a clock signal having a first amplitude corresponding to the operating supply voltage;
the positive voltage input is arranged to receive the programming voltage;
the voltage converter (2) is coupled to the positive voltage input and the clock driver (1), to convert the clock signal to a positive periodic signal having a second amplitude different than the first amplitude; and
a charge pump (3) is provided coupled to the voltage converter (2), for generating negative voltage on the output node in response to the positive periodic signal.

**17.** The circuit of claim 15 or claim 16, wherein the non-volatile memory cell comprises a FLASH EPROM memory cell.

**18.** The circuit of claim 17, wherein the programming supply voltage is approximately 12 volts.

**19.** The circuit of claim 17 or claim 18, wherein the operating supply voltage is approximately 5 volts.

**20.** The circuit of any of claims 17 to 19, wherein the negative voltage has an absolute value greater than the operating supply voltage.

**21.** A FLASH EPROM integrated memory circuit receiving a supply voltage $V_{cc}$ for read operations and a programming potential $V_{PP}$ for programming operations, comprising:

an array of FLASH EPROM storage transistors, storage transistors in the arrays having respective floating gates, sources and drains;
addressing means, coupled to the array, for generating address signals to access selected storage transistors;
a plurality of wordlines, coupled to the floating gates of storage cells in respective rows;
a plurality of bitlines, coupled to drains of storage cells in respective columns;
a plurality of local virtual ground lines, each coupled to the sources of storage cells respective columns;
means for connecting the local virtual ground lines in the array of storage cells with a virtual ground terminal;
means, coupled to the plurality of virtual ground lines, for supplying a positive voltage on virtual ground lines;

a circuit for supplying a negative voltage as claimed in any of claims 1 to 14, coupled to the plurality of wordlines, for supplying a negative gate erasing potential on wordlines whilst the positive voltage is supplied to the virtual ground lines, thereby to remove charge in the floating gates of selected storage transistors.

**22.** The circuit of claim 21, wherein the negative voltage circuit is responsive to the programming potential $V_{PP}$ to generate the negative gate erasing voltage on an output node.

**23.** The circuit of claim 22, wherein within the negative voltage circuit:

the clock driver (1) is arranged to supply a clock signal having an amplitude corresponding to Vcc;
the positive voltage input is arranged to receive $V_{PP}$;
the voltage converter (2) is coupled to the positive voltage input and the clock driver, to convert the clock signal to a positive periodic signal having a particular amplitude different from $V_{CC}$; and
a charge pump (3) is provided coupled to the voltage converter (2), for generating negative voltage on the output node in response to the positive periodic signal.

**Patentansprüche**

**1.** Schaltkreis zum Erzeugen einer negativen Spannung an einem Ausgangsknoten, und zwar aus ersten und zweiten positiven Spannungen, mit:

einem Takttreiber (1) für den Empfang der ersten positiven Spannung und zum Erzeugen eines positiven Taktsignals, welches eine Amplitude hat, welche zwischen Masse und der ersten positiven Spannung liegt,
einem positiven Spannungseingang, der dafür ausgelegt ist, die zweite positive Spannung aufzunehmen,
einer ersten Einrichtung, die mit dem positiven Spannungseingang und dem Takttreiber (1) verbunden ist, um ein positives, periodisches Signal zu erzeugen, und
einer zweiten Einrichtung, die mit der ersten Einrichtung verbunden ist, um an dem Ausgangsknoten in Reaktion auf das positive periodische Signal die negative Spannung zu erzeugen,
wobei der Schaltkreis dadurch gekennzeichnet ist, daß
die erste Einrichtung einen Spannungswandler (2) aufweist, der mit dem positiven Spannungseingang und dem Takttreiber (1) verbunden ist, wobei der Spannungswandler einen Spannungsabsenkschaltkreis (21) aufweist, um die zweite positive Spannung auf eine bestimmte Spannung abzusenken, und einen Treiber aufweist, der mit dem Takttreiber verbunden ist, um in Reaktion auf das Taktsignal und die bestimmte Spannung das positive periodische Signal in ein Taktsignal umzuwandeln, wobei das positive periodische Signal eine bestimmte Amplitude hat, die größer ist als die erste positive Spannung.

2. Schaltkreis nach Anspruch 1, wobei der Treiber einen ersten Transistor (26) aufweist, der durch das positive Taktsignal getrieben wird, sowie einen zweiten Transistor (30) aufweist, der durch eine invertierte Version des positiven Taktsignals getrieben wird, so daß die ersten und zweiten Transistoren eine wechselnde Leitfähigkeit haben, welche bewirkt, daß das positive periodische Signal erzeugt wird.

3. Schaltkreis nach Anspruch 2, wobei der Treiber weiterhin eine verriegelungsartige Gestaltung der Transistoren (23, 24, 27, 28) aufweist, die zwischen den Spannungsabsenkschaltkreis (21) und die ersten und zweiten Transistoren geschaltet sind und dafür ausgelegt sind, daß die bestimmte Spannung, die durch den Spannungsabsenkschaltkreis erzeugt wird, abwechselnd an den Gates von Transistoren in der verriegelungsartigen Konfiguration angelegt wird, um einen Gleichstrom zu eliminieren.

4. Schaltkreis nach Anspruch 3, wobei der Treiber weiterhin einen zweiten Spannungsabsenkschaltkreis (25, 29) aufweist, der zwischen die verriegelungsartige Konfiguration (23, 24, 27, 28) und die ersten und zweiten Transistoren (26, 30) geschaltet ist, um zu verhindern, daß die gesamte bestimmte Spannung während des Übergangs an den ersten oder zweiten Transistoren angelegt wird.

5. Schaltkreis nach Anspruch 1, wobei die zweite Einrichtung zum Erzeugen einer negativen Spannung eine Ladungspumpe (3) aufweist.

6. Schaltkreis nach Anspruch 5, wobei der Ausgangsknoten eine Kapazität hat und die Ladungspumpe (3) aufweist:

einen ersten Kondensator (41), der einen ersten Anschluß und einen zweiten Anschluß hat, wobei der erste Anschluß mit dem Spannungswandler (2) verbunden ist, um das positive periodische Signal aufzunehmen, einen Klemmschaltkreis (43), der mit dem zweiten Anschluß des ersten Kondensators verbunden ist, um den zweiten Anschluß an ein maximales Potential anzuklemmen, und einen Schalter (44), der zwischen den zweiten Anschluß des ersten Kondensators (41) und den Ausgangsknoten geschaltet ist, und der einen leitfähigen Zustand hat, wenn Spannung an dem zweiten Anschluß des ersten Kondensators unterhalb des Spannungswertes an dem Ausgangsknoten absinkt.

7. Schaltkreis nach Anspruch 6, wobei der erste Kondensator aufweist:

einen Kondensator, der als Transistor (41) ausgestaltet ist, und der eine Source und eine Drain hat, die mit dem ersten Anschluß des ersten Kondensators verbunden sind, sowie ein Gate, welches mit dem zweiten Anschluß des ersten Kondensators verbunden ist.

8. Schaltkreis nach Anspruch 7, wobei der durch den Kondensator ausgestaltete Transistor aus einem p-Kanal MOS-Transistor besteht, einschließlich eines n-Wells, der mit dem ersten Anschluß des ersten Kondensators verbunden ist.

9. Schaltkreis nach Anspruch 6, wobei der Klemmschaltkreis aufweist:

einen als Diode ausgestalteten Transistor (43), der zwischen den zweiten Anschluß des ersten Kondensators und Masse geschaltet ist.

10. Schaltkreis nach Anspruch 6, wobei der Schaltkreis aufweist:

einen als Diode ausgestalteten Transistor (44), der zwischen den zweiten Anschluß des ersten Kondensators und den Ausgangsknoten geschaltet ist.

11. Schaltkreis nach Anspruch 5, wobei die Ladungspumpe aufweist:

einen als Kondensator ausgestalteten Transistor (41), dessen Source und Drain mit einem ersten Anschluß und dessen Gate mit einem zweiten Anschluß verbunden sind, einen ersten Transistor (43), der als Diode ausgestaltet ist, und der zwischen den zweiten Anschluß des als Kondensator ausgestalteten Transistors und Masse geschaltet ist, und einen zweiten als Diode ausgestalteten Transistor (44), der zwischen den zweiten Anschluß des als Kondensator ausgestalteten Transistors und den Ausgangsknoten gelegt ist.

12. Schaltkreis nach Anspruch 11, wobei der als Kondensator ausgestaltete Transistor, der erste als Diode ausgestaltete Transistor und der Transistor, der als zweiter als Diode ausgestaltet wird, P-Kanal-Transistoren aufweisen.

13. Schaltkreis nach Anspruch 12, wobei der als Kondensator ausgestaltete Transistor (41) einen n-Well aufweist, der dafür ausgelegt ist, die positiven periodischen Signale zu erfassen.

14. Schaltkreis nach Anspruch 1, wobei die erste positive Spannung einer Betriebsspannung entspricht, die geringer ist als die zweite positive Spannung.

15. Speicherschaltkreis, welcher dafür ausgelegt ist, eine Betriebsspannungszufuhr und eine Programmzufuhrspannung aufzunehmen, mit:

einer nicht flüchtigen Speicherzelle, die ein Gate und eine Source hat,
einem Schaltkreis zum Erzeugen einer negativen Spannung nach einem der Ansprüche 1 bis 14, wobei der Schaltkreis so mit der Programmierzufuhrspannung als zweite positive Spannung verbunden ist, daß sie die negative Spannung an einem Ausgangsknoten erzeugt, und Einrichtungen zum Verbinden des Gates an einer nicht flüchtigen Speicherzelle mit dem Ausgangsknoten des negativen Spannungsschaltkreises, um die nicht flüchtige Speicherzelle zu löschen.

16. Schaltkreis nach Anspruch 15, wobei innerhalb des negativen Spannungsschaltkreises der Takttreiber (1) so angeordnet ist, daß er ein Taktsignal noch zuführen kann, welches eine erste Amplitude hat, die der Betriebszufuhrspannung entspricht, wobei der positive Spannungseingang dafür ausgelegt ist, die Programmierspannung aufzunehmen,

der Spannungswandler (2) so mit dem positiven Spannungseingang und dem Takttreiber (1) verbunden ist, daß er das Taktsignal in ein positives periodisches Signal umwandelt, welches eine zweite Amplitude hat, das sich von der ersten Amplitude unterscheidet, und eine Ladungspumpe (3) vorgesehen ist, die mit dem Spannungswandler (2) verbunden ist, um eine negative Spannung am Ausgangsknoten in Reaktion auf das positive periodische Signal zu erzeugen.

17. Schaltkreis nach Anspruch 15 oder 16, wobei die nicht flüchtige Speicherzelle eine FLASH EPROM-Speicherzelle aufweist.

18. Schaltkreis nach Anspruch 17, wobei die Programmzufuhrspannung näherungsweise 12 V beträgt.

19. Schaltkreis nach Anspruch 17 oder 18, wobei die Betriebszufuhrspannung näherungsweise 5 V beträgt.

20. Schaltkreis nach einem der Ansprüche 17 bis 19, wobei die negative Spannung einen Absolutwert hat, der größer ist als die Betriebszufuhrspannung.

21. FLASH EPROM, welches in einen Speicherschaltkreis integriert ist, mit einer Zufuhrspannung $V_{CC}$ für Lesevorgänge und ein Programmierpotential $V_{PP}$ für Programmvorgänge, mit:

einem Feld von FLASH EPROM Speichertransistoren, wobei Speichertransistoren in den Feldern entsprechende erdfreie Gates, Sources und Drains haben,
Adressiereinrichtungen, die mit dem Array verbunden sind, um Adreßsignale für den Zugriff auf ausgewählte Speichertransistoren zu erzeugen,
einer Mehrzahl von Wortleitungen, die mit den erdfreien Gates der Speicherzellen in entsprechenden Reihen verbunden sind,
einer Mehrzahl von Bitleitungen, die mit den Drains von Speicherzellen in entsprechenden Spalten verbunden sind,
einer Mehrzahl von lokalen virtuellen Masseleitungen, die jeweils mit den Sources der Speicherzellen in entsprechenden Spalten verbunden sind,
Einrichtungen zum Verbinden der lokalen virtuellen Masseleitungen in dem Array von Speicherzellen mit einem virtuellen Masseanschluß,
Einrichtungen, die mit der Mehrzahl von virtuellen Masseleitungen verbunden sind, um eine positive Spannung an virtuellen Masseleitungen anzulegen,
einem Schaltkreis für das Zuführen einer negativen Spannung, wie es in einem der Ansprüche 1 bis 14 beansprucht wird, welche mit der Mehrzahl von Wortleitungen verbunden sind, um ein negatives Gatelöschpotential an den Wortleitungen anzulegen, während die positive Spannung an den virtuellen Masseleitungen angelegt wird, um dadurch Ladung von den erdfreien Gates der ausgewählten Speichertransistoren zu entfernen.

22. Schaltkreis nach Anspruch 21, wobei der negative Spannungsschaltkreis auf das Programmierpotential $V_{PP}$ reagiert, um die negative Gatelöschspannung an einem Ausgangsknoten zu erzeugen.

23. Schaltkreis nach Anspruch 22, wobei innerhalb des negativen Spannungsschaltkreises:

der Takttreiber (1) dafür ausgelegt ist, ein Taktsignal zuzuführen, welches eine Amplitude hat, die $V_{CC}$ entspricht,

der positive Spannungseingang so angeordnet ist, daß er $V_{PP}$ empfängt,

der Spannungswandler (2) mit dem positiven Spannungseingang und dem Takttreiber verbunden ist, um das Taktsignal in ein positives periodisches Signal umzuwandeln, welches eine bestimmte Amplitude hat, die sich von $V_{CC}$ unterscheidet, und

eine Ladungspumpe (3) vorgesehen ist, die mit dem Spannungswandler (2) verbunden ist, um eine negative Spannung an dem Ausgangsknoten in Reaktion auf das positive periodische Signal zu erzeugen.

**Revendications**

1. Circuit destiné à engendrer, à partir de première et seconde tensions positives, une tension négative au niveau d'un noeud de sortie, comprenant :

un circuit d'attaque (1) d'horloge destiné à recevoir la première tension positive et à engendrer un signal d'horloge positif ayant une amplitude entre la masse et la première tension positive ;

une entrée de tension positive agencée pour recevoir la seconde tension positive ;

un premier moyen, raccordé à l'entrée de tension positive et au circuit d'attaque (1) d'horloge pour engendrer un signal périodique positif ; et

un second moyen, raccordé au premier moyen, destiné à engendrer, en réponse au signal périodique positif, la tension négative sur le noeud de sortie ;

le circuit étant caractérisé :

en ce que le premier moyen comprend un convertisseur (2) de tension, raccordé à l'entrée de tension positive et au circuit d'attaque (1) d'horloge, le convertisseur de tension comprenant :

un circuit (21) de chute de tension destiné à faire chuter la seconde tension positive jusqu'à une tension particulière ; et

un circuit d'attaque, raccordé au circuit d'attaque d'horloge, destiné à convertir le signal d'horloge en un signal périodique positif en réponse au signal d'horloge et à la tension particulière, le signal périodique positif ayant une amplitude particulière plus grande que la première tension positive.

2. Circuit selon la revendication 1, dans lequel le circuit d'attaque comprend un premier transistor (26) attaqué par le signal d'horloge positif, et un second transistor (30) attaqué par une version inversée du signal d'horloge positif, de façon que les premier et second transistors aient une conductivité alternative faisant que le signal périodique positif est engendré.

3. Circuit selon la revendication 2, dans lequel le circuit d'attaque comprend en outre une configuration du type verrou de transistors (23, 24, 27, 28) connectée entre le circuit (21) de chute de tension et les premier et second transistors, et agencée de façon que la tension particulière engendrée par le circuit de chute de tension soit appliquée alternativement aux grilles des transistors à l'intérieur de la configuration du type verrou pour éliminer le courant continu.

4. Circuit selon la revendication 3, dans lequel le circuit d'attaque comprend en outre un second circuit (25, 29) de chute de tension, raccordé entre la configuration (23, 24, 27, 28) du type verrou et les premier et second transistors (26, 30), pour éviter d'appliquer la totalité de la tension particulière aux bornes du premier ou du second transistor pendant la transition.

5. Circuit selon la revendication 1, dans lequel le second moyen destiné à engendrer une tension négative comprend une pompe à charge (3).

6. Circuit selon la revendication 5, dans lequel le noeud de sortie a une capacitance et dans lequel la pompe à charge (3) comprend :

un premier condensateur (41) ayant une première borne et une seconde borne, la première borne étant raccordée au convertisseur (2) de tension pour recevoir le signal périodique positif ;

un circuit (43) de fixation de niveau raccordé à la seconde borne du premier condensateur, pour fixer, à un potentiel maximal, le niveau de la seconde borne ; et

un interrupteur (44) raccordé entre la seconde borne du premier condensateur (41) et le noeud de sortie, ayant un état conducteur lorsque la tension sur la seconde borne du premier condensateur tombe au-dessous de la tension sur le noeud de sortie.

7. Circuit selon la revendication 6, dans lequel le premier condensateur comprend :

un transistor (41) configuré en condensateur ayant une source et un drain raccordés à la première borne du premier condensateur et une grille raccordée à la seconde borne du premier condensateur.

8. Circuit selon la revendication 7, dans lequel le transistor configuré en condensateur est constitué d'un transistor MOS (à métal-oxyde-semi-conducteur) à canal p incluant un puits de type n raccordé à la première borne du premier condensateur.

9. Circuit selon la revendication 6, dans lequel le circuit de fixation de niveau comprend :

un transistor (43) configuré en diode, raccordé entre la seconde borne du premier condensateur et la masse.

10. Circuit selon la revendication 6, dans lequel l'interrupteur comprend :

un transistor (44) configuré en diode, raccordé entre la seconde borne du premier condensateur et le noeud de sortie.

11. Circuit selon la revendication 5, dans lequel la pompe à charge comprend :

un transistor (41) configuré en condensateur ayant une source et un drain raccordés à une première borne et une grille raccordée à une seconde borne ;
un premier transistor (43) configuré en diode, raccordé entre la seconde borne du transistor configuré en condensateur et la masse ; et
un second transistor (44) configuré en diode, raccordé entre la seconde borne du transistor configuré en condensateur et le noeud de sortie.

12. Circuit selon la revendication 11, dans lequel le transistor configuré en condensateur, le premier transistor configuré en diode et le second transistor configuré en diode comprennent des transistors à canal P.

13. Circuit selon la revendication 12, dans lequel le transistor (41) configuré en condensateur comprend un puits de type n connecté pour recevoir le signal périodique positif.

14. Circuit selon la revendication 1, dans lequel la première tension positive correspond à une tension de fonctionnement plus petite que la seconde tension positive.

15. Circuit de mémoire agencé pour recevoir une tension d'alimentation de mise en oeuvre et une tension d'alimentation de programmation, comprenant :

une cellule de mémoire non volatile comportant une grille et une source ;

un circuit destiné à engendrer une tension négative, tel que revendiqué dans l'une quelconque des revendications 1 à 14, le circuit étant raccordé à la tension d'alimentation de programmation en tant que seconde tension positive, pour engendrer la tension négative sur un noeud de sortie ; et
un moyen destiné à connecter la grille de la cellule de mémoire non volatile au noeud de sortie du circuit de tension négative pour effacer la cellule de mémoire non volatile.

16. Circuit selon la revendication 15, dans lequel, à l'intérieur du circuit de tension négative :

le circuit d'attaque (1) d'horloge est agencé pour délivrer un signal d'horloge ayant une première amplitude correspondant à la tension d'alimentation de mise en oeuvre ;
l'entrée de tension positive est agencée pour recevoir la tension de programmation ;
le convertisseur (2) de tension est raccordé à l'entrée de tension positive et au circuit d'attaque (1) d'horloge, pour convertir le signal d'horloge en un signal périodique positif ayant une seconde amplitude différente de la première amplitude ; et
il est prévu une pompe à charge (3) raccordée au convertisseur (2) de tension, pour engendrer, en réponse au signal périodique positif, une tension négative sur le noeud de sortie.

17. Circuit selon la revendication 15 ou la revendication 16, dans lequel la cellule de mémoire non volatile comprend une cellule de mémoire d'EPROM (mémoire morte programmable et effaçable) flash.

18. Circuit selon la revendication 17, dans lequel la tension d'alimentation de programmation est d'environ 12 volts.

19. Circuit selon la revendication 17 ou la revendication 18, dans lequel la tension d'alimentation de mise en oeuvre est d'environ 5 volts.

20. Circuit selon l'une quelconque des revendications 17 ou 19, dans lequel la tension négative a une valeur absolue plus grande que la tension d'alimentation de mise en oeuvre.

21. Circuit intégré de mémoire EPROM flash recevant une tension $V_{CC}$ d'alimentation pour des opérations de lecture et un potentiel Vpp de programmation destiné à des opérations de programmation comprenant :

une matrice de transistors de mémorisation du type EPROM flash, les transistors de mémorisation de la matrice ayant des grilles flottantes, des sources et des drains, respectifs ;

un moyen d'adressage, raccordé à la matrice, pour engendrer des signaux d'adresse pour accéder à des transistors de mémorisation choisis ;

une pluralité de lignes de mots, raccordée aux grilles flottantes des cellules de mémorisation dans des rangées respectives ;

une pluralité de lignes de bits, raccordée aux drains des cellules de mémorisation dans des colonnes respectives ;

une pluralité de lignes de masse virtuelle locale, chacune raccordée aux sources des cellules de mémorisation des colonnes respectives ;

un moyen destiné à connecter les lignes de masse virtuelle locale de la matrice de cellules de mémorisation avec une borne de masse virtuelle ;

un moyen, raccordé à la pluralité de lignes de masse virtuelle, destiné à délivrer une tension positive sur les lignes de masse virtuelle ;

un circuit destiné à délivrer une tension négative, tel que revendiqué dans l'une quelconque des revendications 1 à 14, raccordé à la pluralité de lignes de mots, pour délivrer un potentiel de grille négatif, d'effacement, sur des lignes de mots tandis que la tension positive est délivrée aux lignes de masse virtuelle, en retirant ainsi la charge se trouvant dans les grilles flottantes de transistors de mémorisation choisis.

**22.** Circuit selon la revendication 21, dans lequel le circuit de tension négative est sensible au potentiel Vpp de programmation pour engendrer, sur un noeud de sortie, la tension négative de grille, d'effacement.

**23.** Circuit selon la revendication 22, dans lequel, à l'intérieur du circuit de tension négative :

le circuit d'attaque (1) d'horloge est agencé pour délivrer un signal d'horloge ayant une amplitude correspondant à $V_{CC}$ ;

l'entrée de tension positive est agencée pour recevoir $V_{PP}$ ;

le convertisseur (2) de tension est raccordé à l'entrée de tension positive et au circuit d'attaque d'horloge, pour convertir le signal d'horloge en un signal périodique positif ayant une amplitude particulière différente de $V_{CC}$ ; et

il est prévu une pompe à charge (3), raccordée au convertisseur (2) de tension, pour engendrer, en réponse au signal périodique positif, une tension négative sur le noeud de sortie.

FIG.-1

FIG.—2A

FIG.—2B

FIG.—2C

EP 0 700 598 B1

FIG.—3A

FIG.—3B

FIG.—3C

NVPP
CLKP

node 42

node 42-CLKP

EP 0 700 598 B1

FIG.—4

TO SENSE AMPS AND
PROGRAM DATA—IN
STRUCTURES

FIG.—5

FIG.—6